(19) **Europäisches Patentamt**
**European Patent Office**
**Office européen des brevets**

(11) **EP 1 289 141 B1**

(12) **EUROPEAN PATENT SPECIFICATION**

(45) Date of publication and mention
of the grant of the patent:
**10.10.2007  Bulletin 2007/41**

(51) Int Cl.:
***H03H 11/48*** *(2006.01)*

(21) Application number: **01830537.5**

(22) Date of filing: **10.08.2001**

(54) **Integrated electronic circuit including non-linear devices**

Integrierte elektronische Schaltung mit nicht-linearen Vorrichtungen

Circuit électronique intégré comportant des dispositifs non-linéaires

(84) Designated Contracting States:
**DE FR GB IT**

(43) Date of publication of application:
**05.03.2003  Bulletin 2003/10**

(73) Proprietors:
• **STMicroelectronics S.r.l.**
**20041 Agrate Brianza (Milano) (IT)**
• **International Business Machines Corporation**
**Armonk, NY 10504 (US)**

(72) Inventors:
• **Zuffada, Maurizio,**
**c/o STMicroelectronics S.r.l.**
**20041 Agrate Brianza (MI) (IT)**

• **Betti, Giorgio,**
**c/o STMicroelectronics S.r.l.**
**20041 Agrate Brianza (MI) (IT)**
• **Chrappan Soldavini F,**
**STMicroelectronics S.r.l.**
**20041 Agrate Brianza (MI) (IT)**
• **Hassner, Martin Aureliano**
**Mountain View,**
**94040 - California (US)**

(74) Representative: **Botti, Mario**
**Botti & Ferrari S.r.l.,**
**Via Locatelli, 5**
**20124 Milano (IT)**

(56) References cited:
**US-A- 3 603 903**           **US-A- 6 087 823**
**US-B1- 6 211 753**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

The present invention relates generally to a non-linear electronic device and, more particularly, to a non-linear inductor.

More specifically, but not exclusively, the invention relates to an electronic circuit device that may be integrated on a semiconductor substrate.

Moreover, the invention may be integrated or used in association with a circuit network including non-linear devices.

PRIOR ART

As is well known in this specific technical field, the data detection for transmission channels is based on the use of a network of non-linear devices.

Actually, data detection with non-linear devises is gaining more and more market attention because of the simplicity of the circuit network and a corresponding lower production cost.

A circuit network including non-linear devices requires that the non-linearity of such devices be well controlled and follow a well-defined rule.

Only if these conditions are respected the resulting network could provide some advantages in data detection if compared with others more complex known solutions.

The devices used in this kind of network are usually capacitor and inductor that have a non-linear relation between capacitance and voltage for capacitor and inductance and current for inductor.

One of the main difficulties for manufacturing an integrated circuit network including non-linear devices is due to the fact that the non-linear components must be provided as discrete elements. As a matter of fact, an integrated non-linear capacitor or inductor is hard to realize according to the current technologies.

For instance, the US patent No. 6,166,604 relates to a semiconductor amplifier including a distortion compensating circuit. That amplifier comprises a non-linear amplifying element connected to an integrated capacitor preventing a direct current from flowing through a passive circuit. The integrated capacitor is realized in a known manner.

The US Patent 6,060,934 of Landolt discloses an integrated circuit including a pseudo-capacitor showing a linear behavior.

Up to now no solutions are known for easily integrating an electronic circuit including non-linear passive components.

The technical problem of the present invention is that of implementing non-linear passive devices into a semiconductor electronic circuit thus allowing the construction of a network of non-linear devices for data detection in transmission channels.

SUMMARY OF THE INVENTION

The scope of the invention is to provide a circuit to integrate a non-linear passive device and, more specifically, a non-linear inductor.

More specifically the scope of the invention is to provide a non linear inductor with the following relationship:

$$L = L_0 \cdot \frac{1}{1 - k \cdot I_L^2}$$

The solution idea on which the invention is based is that of realizing such a non-linear passive device by using active components that are connected in a feedback loop in order to emulate the same behavior of the non-linear passive device.

Therefore, the present invention utilizes active devices operating in a feedback loop to implement the function of a non-linear inductor.

The technical problem is solved by an integrated electronic circuit defined by the enclosed claim 1 and following.

Other objects, features, and advantages of the present invention will become apparent from the following detailed description. It should be understood, however, that the detailed description and specific examples, while indicating preferred embodiments of present invention, are given by way of illustration only and various modifications may naturally be performed without deviating from the present invention.

A more complete understanding of the present invention may be had by reference to the following detailed description when taken in conjunction with the accompanying drawings wherein:

BRIEF DESCRIPTION OF THE DRAWINGS

FIG. 1 is a schematic blocks diagram of a first embodiment of an electronic circuit in accordance with the present invention;

FIG. 2 is a detailed schematic diagram of the electronic circuit of the present invention;

FIG. 3 is a graph showing the inductance value versus current for the electronic circuit of figure 2;

FIG. 4 is a graph showing the flow value versus current for the electronic circuit of figure 2.

DETAILED DESCRIPTION

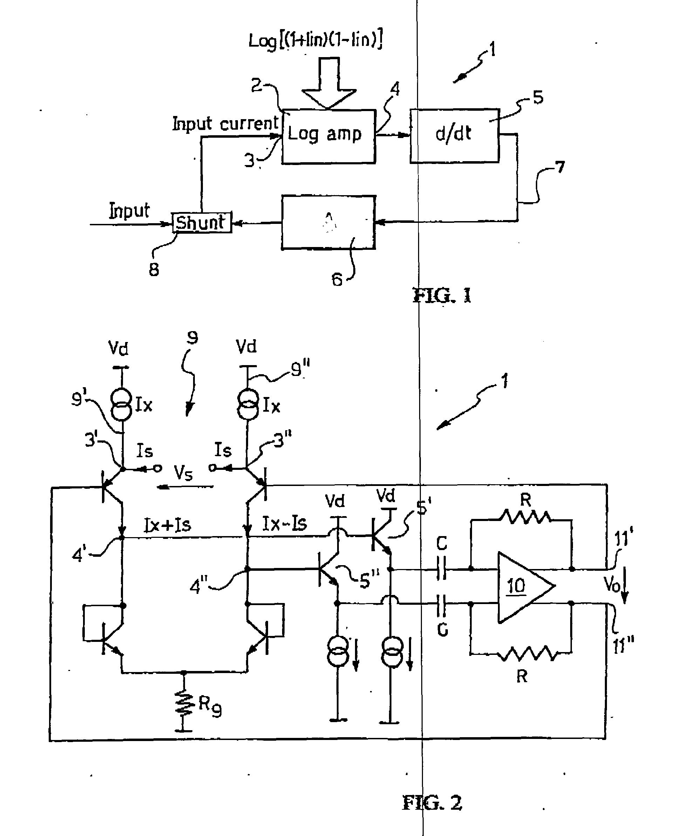

Referring now to figure 1, a schematic block diagram of an embodiment of an integrated electronic circuit 1 in accordance with the present invention is shown.

The integrated electronic circuit 1 implements a non-linear inductor Leq and, more specifically, a non linear inductor having the following relationship:

$$L = L_0 \cdot \frac{1}{1 - k \cdot I_L^{\,2}}$$

The electronic circuit 1 includes a fist logarithmic amplifier block 2 receiving an input current Iin at an input terminal 3. The input current Iin is drawn through a shunt block 8 or node receiving as input just the input current.

The logarithmic amplifier block 2 has an output 4 connected to an input of a derivative block 5 performing a d/dt function on the input current signal Iin.

A gain block 6 is cascade connected, in a downstream manner, to the derivative block 5.

The input is connected to the output of an amplifying stage (block A) and the current that is flowing from the input node is read by a shunt device and fed to a logarithmic amplifier.

A feedback connection 7, including the gain block 6, closes a feedback loop between the output of the derivative block 5 and the shunt block 8.

The inventive solution is implemented by interconnecting several blocks into a feedback loop as shown in figure 1, thus realizing a non-linear inductor.

The implemented function will be hereinafter explained starting with the relationship between voltage and current at the inputs terminals of the electronic circuit 1:

$$V_{in} = A \cdot \frac{d}{dt}\left( \log\left( \frac{1 + I_{in}}{1 - I_{in}} \right) \right)$$

As may be appreciated, the gain term A represents the function of the gain block 6, the d/dt 0 portion is the operative result presented by the output of the derivative block 5, while the logarithmic block 2 works on the input current signal Iin.

Now, solving the derivative term:

$$\frac{d}{dt}\left(\log\left(\frac{1+I_{in}}{1-I_{in}}\right)\right) = \frac{1}{\left(\frac{1+I_{in}}{1-I_{in}}\right)} \cdot \frac{\frac{dI_{in}}{dt}\cdot(1-I_{in})+\frac{dI_{in}}{dt}\cdot(1+I_{in})}{(1-I_{in})^2}$$

and simplifying:

$$\frac{\frac{dI_{in}}{dt}\cdot(1-I_{in}+1+I_{in})}{(1+I_{in})\cdot(1-I_{in})} = \frac{2\cdot\frac{dI_{in}}{dt}}{(1-I_{in}^2)}$$

we obtain a final result in the following relationship (Eq: 1):

$$V_{in} = A\cdot\frac{d}{dt}\left(\log\left(\frac{1+I_{in}}{1-I_{in}}\right)\right) = A\cdot\frac{2}{(1-I_{in}^2)}\cdot\frac{dI_{in}}{dt} \qquad \text{Eq:1}$$

As previously remarked, the relationship between voltage and current for a non-linear inductor is the following (Eq:2):

$$V_L = L(I_L)\cdot\frac{dI_L}{dt} \qquad \text{Eq:2}$$

By comparing the equations 1 and 2, a new relationship may be obtained (Eq: 3):

$$L(I_L) = A\cdot\frac{2}{(1-I_{in}^2)} \qquad \text{Eq:3}$$

This equation (Eq:3) gives a relationship between current and voltage that follows the required behavior, apart for a k factor that could be easily added by inserting a gain stage before the logarithmic amplifier 2.

One possible embodiment of the inventive circuit 1 is shown in the schematic diagram of figure 2.

The logarithmic amplifier block 2 is implemented by a transconductance differential cell 9 having differential current inputs 3', 3" and corresponding current outputs 4', 4".

The cell 9 has a two symmetric transistors branches 9', 9" each coupled to a first voltage supply reference Vd through current generator Ix and to a second voltage reference GND through a resistor R9 or, as an alternative, a current generator.

The transistors of each branch 9', 9" could be bipolar transistors or a bipolar and a MOS transistor. More specifically, two input bipolar transistors and two output bipolar transistors are used in this embodiment.

The current inputs 3', 3" are set between the current generator Ix and the first input transistor of each branch 9', 9"; while the current outputs 4', 4" are set between the input and the output transistors of each branch.

Each current output 4', 4" (Ix+Is; Ix-Is) is connected to the driving terminal of a bipolar transistor 5', 5" having the conduction terminal coupled to the first voltage reference Vd and to the second voltage reference GND respectively. The second conduction terminal of each transistor 5', 5" is coupled to the second voltage reference GND through a current generator.

The second conduction terminal of each transistor 5', 5" is also coupled, through a capacitor C, to a corresponding input terminal 10', 10" of a double ended gain stage 10 having a resistor R feedback connected between each corresponding output 11', 11" and input 10', 10" terminals.

A voltage potential Vo is detectable between the output terminals 11', 11".

Both the output terminals 11', 11' of the gain stage 10 are feedback connected to the input terminals 3', 3" thus closing the feedback loop 7.

The activity of the electronic circuit 1 shown in figure 2 may be summarized by the following relationship:

$$Vo = Vs = \frac{d}{dt}\left\{V_T \ln\left(\frac{1 + \dfrac{Is}{Ix}}{1 - \dfrac{Is}{Ix}}\right)\right\} \cdot C \cdot R$$

$$Vs = \frac{C \cdot R \cdot V_T}{Ix} \cdot 2 \cdot \frac{1}{1 - \left(\dfrac{Is}{Ix}\right)^2} \cdot \frac{dIs}{dt} = Leq \cdot \frac{dIs}{dt}$$

where Vs is the input voltage, Is is the input current, Ix is the biasing current and Leq is the equivalent inductance value of the whole circuit 1 according to the following formula:

$$Leq = \frac{C \cdot R \cdot V_T \cdot 2}{Ix} \cdot \frac{1}{1 - \left(\dfrac{Is}{Ix}\right)^2}$$

The corresponding flow value is given by:

$$\int Vs \cdot dt = C \cdot R \cdot V_T \cdot \ln\left(\frac{1 + \dfrac{Is}{Ix}}{1 - \dfrac{Is}{Ix}}\right) = \phi(Is)$$

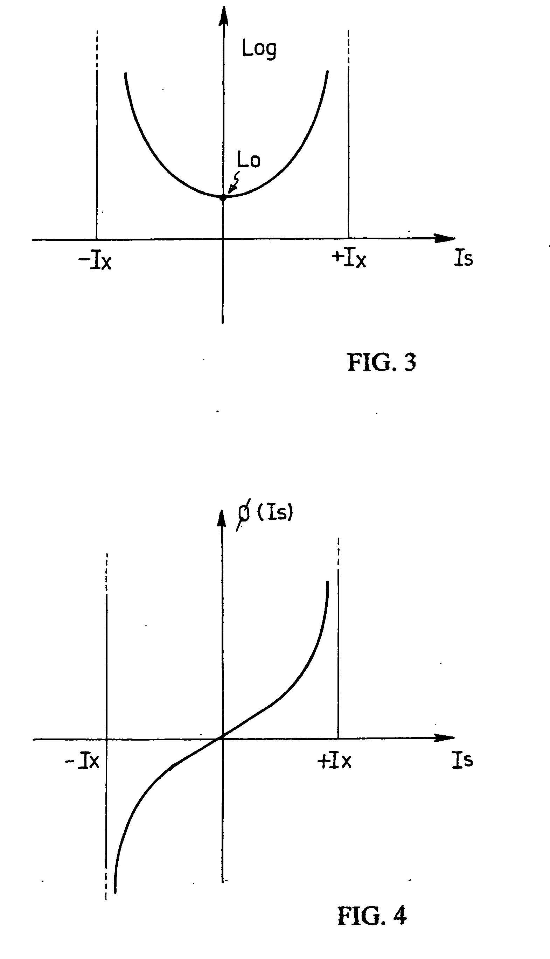

The graph diagrams of the figures 3 and 4 show the evolution of inductance value Lep and the flow value Q versus the current input Is for the circuit of the invention.

Having described and illustrated the principles of the invention in a preferred embodiment thereof, it should be apparent that the invention can be modified in arrangement and detail without departing from such principles..

**Claims**

**1.** Integrated electronic circuit (1) comprising at least one active block (2, 5, 6), **characterized in that** said at least one active block comprises a logarithmic amplifier block (2) receiving an input current (Iin) at an input terminal (3) and having an output (4) coupled to said input terminal (3) by a feedback loop, so that said at least one active block realizes a non-linear inductor.

2. Integrated electronic circuit according to claim 1, **characterized in that** it further comprises a derivative block (5) downstream connected to said logarithmic amplifier block (2) and a final gain block (6) downstream connected to the derivative block (5), wherein said feedback loop is between an output of said gain block (6) and said input terminal (3) of said logarithmic amplifier block (2).

3. Integrated electronic circuit according to claim 2, **characterized in that** it further comprises a shunt block (8) between said output it of said gain block (6) and said input terminal (3) of said logarithmic amplifier block (2).

4. Integrated electronic circuit according to claim 1, **characterized in that** said logarithmic amplifier block (2) is implemented by a transconductor differential cell (9).

5. Integrated electronic circuit according to claim 1, **characterized in that** said non-linear inductor has the following relationship:

$$L = L_0 \cdot \frac{1}{1 - k \cdot I_L^{\,2}}$$

wherein $I_L$ is the non-linear inductor current, k is a gain factor and $L_0$ is an inductance value when the non-linear inductor current is zero.

**Patentansprüche**

1. Integrierte elektronische Schaltung (1) umfassend wenigstens einen aktiven Block (2, 5, 6), **dadurch gekennzeichnet, dass** der wenigstens eine aktive Block einen logarithmischen Verstärkerblock (2) aufweist, der einen Eingangsstrom (Iin) an einem Eingangsanschluss (3) erhält, und der einen Ausgang (4) aufweist, der mit dem Eingangsanschluss (3) über eine Rückkopplungsschleife gekoppelt ist, so dass der wenigstens eine aktive Block eine nichtlineare Induktivität realisiert.

2. Integrierte elektronische Schaltung nach Anspruch 1, **dadurch gekennzeichnet, dass** sie weiterhin einen differenzierenden Block (5) aufweist, der dem logarithmischen Verstärkerblock (2) nachgeschaltet ist, und einen End-Verstärkungsblock (6), der dem differenzierenden Block (5) nachgeschaltet ist, wobei die Rückkopplungsschleife zwischen einem Ausgang des Verstärkungsblocks (6) und dem Eingangsanschluss (3) des logarithmischen Verstärkerblocks (2) vorhanden ist.

3. Integrierte elektronische Schaltung nach Anspruch 2, **dadurch gekennzeichnet, dass** sie weiterhin umfasst einen Shunt-Block (8) zwischen dem Ausgang des Verstärkungsblocks (6) und dem Eingangsanschluss (3) des logarithmischen Verstärkerblocks (2).

4. Integrierte elektronische Schaltung nach Anspruch 1, **dadurch gekennzeichnet, dass** der logarithmische Verstärkerblock (2) durch eine Transkonduktanz-Differential-Zelle (9) implementiert ist.

5. Integrierte elektronische Schaltung nach Anspruch 1, **dadurch gekennzeichnet, dass** die nicht-lineare Induktivität die folgende Beziehung aufweist:

$$L = L_0 \cdot \frac{1}{1 - k \cdot I_L^{\,2}}$$

wobei $I_L$ der nicht-lineare Induktivitätsstrom, k ein Verstärkungsfaktor und $L_0$ ein Induktivitätswert ist, wenn der nichtlineare Induktivitätsstrom 0 ist.

# EP 1 289 141 B1

**Revendications**

1.  Circuit électronique intégré (1) comprenant au moins un bloc actif (2,5,6), **caractérisé en ce que** ledit au moins un bloc actif comprend un bloc amplificateur logarithmique (2) recevant un courant d'entrée (Iin) au niveau d'une borne d'entrée (3) et comportant une sortie (4) couplée à ladite borne d'entrée (3) par une boucle de rétroaction, de façon à ce que ledit au moins un bloc actif réalise un inducteur non linéaire.

2.  Circuit électronique intégré selon la revendication 1, **caractérisé en ce qu'**il comprend en outre un bloc de dérivation (5) en aval raccordé audit bloc amplificateur logarithmique (2) et un bloc de gain final (6) en aval raccordé au bloc de dérivation (5), dans lequel ladite boucle de rétroaction se trouve entre une sortie dudit bloc de gain (6) et ladite borne d'entrée (3) dudit bloc amplificateur logarithmique (2).

3.  Circuit électronique intégré selon la revendication 2, **caractérisé en ce qu'**il comprend en outre un bloc à shunt (8) entre ladite sortie dudit bloc de gain (6) et ladite borne d'entrée (3) dudit bloc amplificateur logarithmique (2).

4.  Circuit électronique intégré selon la revendication 1, **caractérisé en ce que** ledit bloc amplificateur logarithmique (2) est mis en oeuvre par une cellule différentielle de transconducteur (9).

5.  Circuit électronique intégré selon la revendication 1, **caractérisé en ce que** ledit inducteur non linéaire présente la relation suivante :

$$L = L_0 \cdot \frac{1}{1 - k \cdot I_L^2}$$

dans laquelle $I_L$ est le courant de l'inducteur non linéaire, k est un coefficient de gain et $L_o$ est une valeur de capacité lorsque le courant de l'inducteur non linéaire est de zéro.

$$Log[(1+lin)(1-lin)]$$

FIG. 1

FIG. 2

FIG. 3

FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6166604 A

- US 6060934 A